# EUROPEAN PATENT SPECIFICATION

(11) **EP 2 085 495 B1**
(45) Date of publication and mention of the grant of the patent: **23.04.2014**
(21) Application number: 09001304.6
(22) Date of filing: 30.01.2009
(51) Int. Cl.: C23C 16/34, C23C 16/509, H01L 51/52

(54) **Gas barrier layer deposition method**
Ablagerungsverfahren für eine Gassperrschicht
Procédé de dépôt de couche de barrière à gaz

(30) Priority: 01.02.2008 JP 2008022511
(43) Date of publication of application: 05.08.2009
(73) Proprietor: FUJIFILM Corporation, Tokyo 106-8620 (JP)
(72) Inventor: Nakagame, Masami, Odawara-shi Kanagawa (JP); Takahashi, Toshiya, Odawara-shi Kanagawa (JP); Murakami, Tomoo, Odawara-shi Kanagawa (JP); Ooseki, Meiki, Odawara-shi Kanagawa (JP); Fujinami, Tatsuya, Odawara-shi Kanagawa (JP)
(74) Representative: HOFFMANN EITLE

(56) References cited:
- EP-A1- 1 587 153
- US-B1- 6 857 387
- RUNG-YWAN TSAI ET AL: "AMORPHOUS SILICON AND AMORPHOUS SILICON NITRIDE FILMS PREPARED BY APLASMA-ENHANCED CHEMICAL VAPOR DEPOSITION PROCESS AS OPTICAL COATING MATERIALS" APPLIED OPTICS, OPTICAL SOCIETY OF AMERICA, US, vol. 32, no. 28, 1 October 1993 (1993-10-01), pages 5561-5566, XP000398557 ISSN: 0003-6935
- BYUNGWHAN KIM AND SANG HEE KWON: "Use of a neural network to characterize the charge density of PECVD-silicon nitride films" METALS AND MATERIALS INTERNATIONAL, vol. 13, no. 6, December 2007 (2007-12), pages 495-499, XP002605680

## Description

### BACKGROUND OF THE INVENTION

The present invention relates to a gas barrier layer deposition method with which a silicon nitride film serving as a gas barrier layer is formed on a substrate by capacitively coupled chemical vapor deposition. The invention more specifically relates to a gas barrier layer deposition method capable of forming, at a high deposition rate, a colorless transparent silicon nitride film which is highly resistant to permeation by oxygen and water vapor.

Silicon nitride films are employed for the gas barrier layer in various devices and optical elements requiring moisture resistance. The silicon nitride films employed for the gas barrier layer are formed by capacitively coupled plasma-enhanced chemical vapor deposition (hereinafter abbreviated as "CCP-CVD").

CCP-CVD is a technique involving applying a radio frequency voltage (hereinafter referred to as "RF voltage) to two opposing electrodes to generate plasma between the electrodes, thus forming a film.

A known technique in addition to the above-described CCP-CVD is inductively coupled plasma-enhanced chemical vapor deposition (ICP-CVD).

CCP-CVD has the following advantages: The structure is simple; and a gas material is supplied from the electrodes, which enables gas to be uniformly supplied to the whole film-forming area even in the case where the electrodes have an increased surface area (the gas is easily made uniform).

Various other film deposition methods by means of plasma-enhanced chemical vapor deposition have been heretofore proposed (see JP 2004-292877 A).

JP 2004-292877 A describes a method of producing a silicon nitride film by catalytic CVD. According to JP 2004-292877 A, monosilane, ammonia and hydrogen are supplied and catalytically cracked with a wire heated by application of current to deposit a silicon nitride film by CVD on a substrate having a temperature of not more than 160°C. The flow rate ratios of the ammonia and the hydrogen to the monosilane are from 1 to 30 and from 5 to 400, respectively.

In EP 1 587 153 A1, a method of manufacturing an organic EL device is described. The method comprises the formation of a sealing film made of Si and SiNₓ on a surface of the EL element by utilizing a plasma CVD method.

### SUMMARY OF THE INVENTION

At present, CCP-CVD suffers from a plasma electron density of as low as about 1 × 10⁸ to about 1 × 10¹⁰ electrons/cm³ and has difficulties in improving the film deposition rate. In addition, because the electrodes are present in the plasma-generating region, film deposition continued for an extended period of time may cause a film to adhere to and/or deposit onto the electrodes as well to hinder proper film deposition.

Under the circumstances, in equipment that may be used, for example, to form a gas barrier layer against oxygen and water vapor as an elongated polymer film or other material is transported in a longitudinal direction for the purpose of mass production, the polymer film serving as a substrate cannot travel at an improved speed, which may often not ensure high productivity. Film deposition onto the electrodes also limits the length of the polymer film serving as a substrate.

What is more, CCP-CVD requires a high pressure of usually about several tens of Pa to about several hundred Pa to maintain plasma, and in cases where film deposition is continuously carried out in a plurality of film deposition spaces (film deposition chambers) connected to each other, has a deteriorated film quality due to undesired incorporation of a gas in any of the film deposition chambers.

In the silicon nitride film production method described in JP 2004-292877 A, when a silicon nitride film is produced as a gas barrier layer, the gas barrier layer cannot be formed quickly because of a low film deposition rate, thus leading to a decrease in the production efficiency of the gas barrier film.

The present invention has been made to solve the aforementioned conventional problems and it is an object of the present invention to provide a gas barrier layer deposition method capable of forming a colorless transparent silicon nitride film which is highly resistant to permeation by oxygen and water vapor at a high deposition rate.

In order to achieve the above objects, the present invention provides a method of depositing a gas barrier layer, comprising the steps of: continuously letting an elongated substrate out of a roll having the substrate wound thereon; supplying a gas material including silane gas and ammonia gas and a discharge gas including nitrogen gas; continuously carrying out film deposition as the substrate is transported in a longitudinal direction, by depositing a silicon nitride film on the substrate using capacitively coupled chemical vapor deposition to form the gas barrier layer on the substrate; and taking up the substrate having the gas barrier layer formed thereon, wherein a ratio P/Q of RF power P (W) required to form the silicon nitride film to a total gas flow rate Q (sccm) of the silane gas, the ammonia gas and the nitrogen gas is in a range of from 0.4 to 40, characterized in that a ratio Qa/Qs of an ammonia gas flow rate Qa (sccm) to a silane gas flow rate Qs (sccm) is in a range of from 0.4 to 4, a ratio Qs/Q of a silane gas flow rate Qs to the total flow rate Q of the silane gas, the ammonia gas and the nitrogen gas is in a range of from 0.05 to 0.18, the silicon nitride film is deposited at a film deposition pressure of from 10 to 220 Pa, and the temperature of the substrate is adjusted in a range of from 0°C to 150°C.

According to the invention having the features described above, a colorless transparent silicon nitride film which is highly resistant to permeation by oxygen and water vapor can be formed at a high deposition rate.

### BRIEF DESCRIPTION OF THE DRAWING

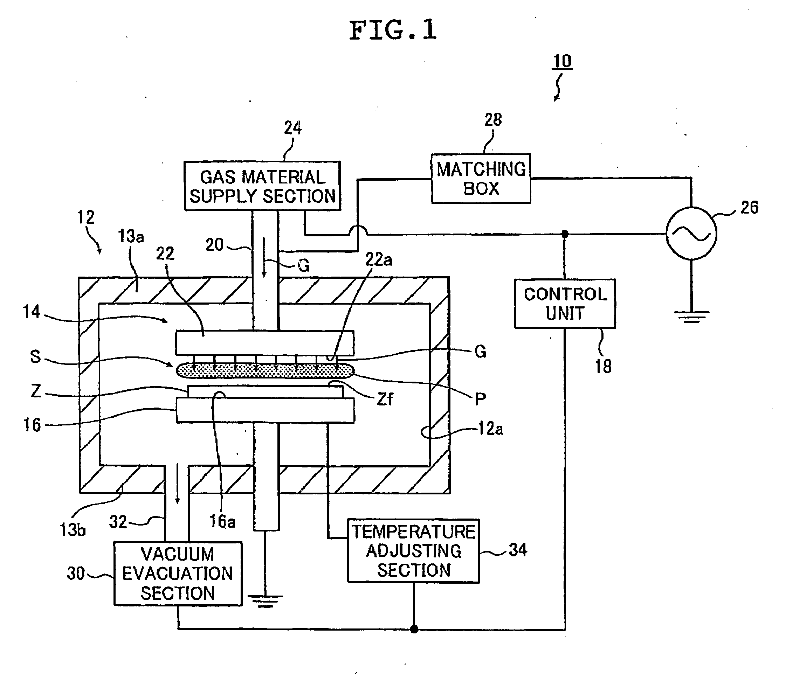

FIG. 1 is a diagram schematically showing a plasma-enhanced CVD device that may be used in a gas barrier layer deposition method.

### DETAILED DESCRIPTION OF THE PREFERRED EMBODIMENTS

On the pages that follow, the gas barrier layer deposition method according to the present invention is described in detail.

Silicon nitride films are employed for the gas barrier layer in various devices and optical elements requiring moisture resistance. The gas barrier layer is required to have high barrier properties against oxygen, water vapor and other gases and optical properties such as color and transparency.

What is more, with a view to achieving mass production with a high productivity, a gas barrier layer is formed by a film deposition method which involves continuously letting an elongated substrate out of a roll having the substrate wound thereon, continuously carrying out film deposition as it is transported in a longitudinal direction, and taking up the substrate following film deposition. In order to improve the productivity or production efficiency in such a method, the substrate travel speed needs to be improved while achieving efficient film deposition. Accordingly, a gas barrier layer needs to be deposited at a film deposition rate exceeding a certain value.

In view of the above, the inventors of the invention have made intensive studies on methods for improving the barrier properties and transparency of silicon nitride films, and also their film deposition rate.

As a result, the inventors of the invention have found that, when a silicon nitride film is formed through CCP-CVD by using a gas material including silane gas (SiH₄ gas) and ammonia gas (NH₃ gas) and a discharge gas including nitrogen gas (N₂ gas), a colorless transparent silicon nitride film (gas barrier layer) which is excellent in barrier properties against gases such as oxygen and water vapor can be produced at a high film deposition rate by adjusting the ratio P/Q to from 0.4 to 40 wherein P represents the radio frequency power (W) (hereinafter referred to as "RF power") required to form the silicon nitride film with the RF power being supplied to the electrode for film deposition and being required in a radio frequency power supply (hereinafter referred to as "RF power supply") for plasma generation, and Q represents the total flow rate (sccm) of the silane gas, ammonia gas and nitrogen gas. The invention has been thus completed.

In the practice of the invention, as described above, the ratio P/Q of the RF power P (W) required to form a silicon nitride film to the total flow rate Q (sccm) of the silane gas, ammonia gas and nitrogen gas is adjusted to 0.4 to 4.0.

By adjusting the ratio P/Q within the above-defined range, a dense gas barrier layer having excellent gas barrier properties such as high resistance to permeation by oxygen and water vapor can be formed under stable discharge with fewer damages to the substrate.

At a ratio P/Q of less than 0.4, SiH₄ is not sufficiently decomposed in the SiH₄ gas (silane gas) so that a silicon nitride film with a large number of Si-H bonds is obtained, leading to reduced gas barrier properties. Therefore, the silicon nitride film formed has a high water vapor transmission rate (hereinafter abbreviated as "WVTR").

On the other hand, at a ratio P/Q exceeding 40, the substrate sustains greater damage during film deposition and its surface is roughened. Therefore, a dense silicon nitride film is not obtained. The silicon nitride film formed has a high WVTR, leading to reduced gas barrier properties.

The total flow rate Q (sccm) of all the gases is not particularly limited but is preferably from 200 to 3,000 sccm. By adjusting the total flow rate Q of all the gases within the foregoing preferable range, a dense film can be easily formed at a high film deposition rate.

The frequency of the RF power applied during film deposition is not particularly limited but is preferably from 13.56 MHz to 60 MHz.

In the gas barrier layer deposition method of the invention, the ratio between the ammonia gas flow rate Qa (sccm) and the silane gas flow rate Qs (sccm) in the silane gas, ammonia gas and nitrogen gas used in forming the silicon nitride film is appropriately set according to the composition (compositional ratio) of the silicon nitride film to be formed so that the ratio Qa/Qs of the ammonia gas flow rate to the silane gas flow rate is from 0.4 to 4.

By adjusting the ratio Qa/Qs of the ammonia gas flow rate to the silane gas flow rate within the above-defined range, preferable results are obtained in terms of transparency and barrier properties against oxygen and water vapor.

At a flow rate ratio Qa/Qs of less than 0.4, the silicon nitride film obtained is rich in silicon. It should be noted here that the silicon nitride film is a transparent film but the silicon film is not. A silicon nitride film whose composition is closer to pure silicon (rich in silicon) may be colored.

On the other hand, at a flow rate ratio Qa/Qs exceeding 4, hydrogen derived from NH₃ gas (ammonia gas) may be incorporated in the silicon nitride film to lower the gas barrier properties. In this case, the WVTR is increased.

In the gas barrier layer deposition method of the invention, the ratio Qs/Q of the silane gas flow rate Qs to the total flow rate Q of all the gases (silane gas, ammonia gas and nitrogen gas) in the silane gas, ammonia gas and nitrogen gas used in forming the silicon nitride film is appropriately set according to the composition (compositional ratio) of the silicon nitride film to be formed so that the ratio Qs/Q of the silane gas flow rate Qs to the total flow rate Q of all the gases is in a range of from 0.05 to 0.18.

By adjusting the flow rate ratio Qs/Q within the above-defined range, a colorless transparent film can be formed at a high deposition rate.

At a flow rate ratio Qs/Q of less than 0.05, the silane gas serving as the starting material of the silicon nitride film is used in a smaller amount, which may reduce the film deposition rate.

On the other hand, at a flow rate ratio Qs/Q exceeding 0.18, the silane gas serving as the starting material of the silicon nitride film is used in an excessive amount to cause excessive reaction in the vapor phase as in plasma, thus generating particles, which then adhere to the surface on which the silicon nitride film is being formed, whereby the silicon nitride film may have low transparency.

In the gas barrier layer deposition method of the invention, the silicon nitride film is deposited at a film deposition pressure of from 10 to 220 Pa.

By adjusting the film deposition pressure within the above-defined range, a colorless film with high transparency can be formed at a specified deposition rate.

At a film deposition pressure of less than 10 Pa, the silane gas and the ammonia gas serving as the starting material of the silicon nitride film are supplied in smaller amounts to the film deposition space, whereby the film deposition rate may be reduced.

On the other hand, at a film deposition pressure exceeding 220 Pa, the silane gas and the ammonia gas serving as the starting material of the silicon nitride film are supplied in excessive amounts to the film deposition space to cause excessive reaction in the vapor phase as in plasma, thus generating particles, which then adhere to the surface on which the silicon nitride film is being formed, whereby the silicon nitride film has reduced transparency.

In the gas barrier layer deposition method of the invention, the silicon nitride film is deposited at a substrate temperature of as low as 0°C to 150°C.

As is well known, in film formation through CVD, a sufficiently dense film can be formed regardless of the gas material used, its flow rate, and the method of plasma generation if the substrate can be used (film deposition can be carried out) at a high temperature. However, film deposition at a high temperature may often be impossible depending on the substrate material and the composition of the undercoat.

In contrast, the present invention can form a silicon nitride film that is sufficiently dense and exhibits high barrier properties against oxygen and water vapor even at a low temperature of not more than 150°C. By adjusting the substrate temperature in a range of from 0°C to 150°C, a dense silicon nitride film that has excellent barrier properties against oxygen and water vapor can also be formed on less heat-resistant substrates such as polymer films and ones having an organic layer formed thereon.

In the invention, by adjusting the substrate temperature in a range of from 0°C to 150°C, for example, a polymer film-based gas barrier layer (moisture barrier film) which is highly resistant to permeation by oxygen and water vapor can be formed with high productivity.

In the gas barrier layer deposition method of the invention, there is no particular limitation on the substrate (film deposition substrate) on which a silicon nitride film is to be formed, and any substrate on which a silicon nitride film can be formed is available. Exemplary substrates that may be preferably used include ones on which no film can be deposited at a high temperature including polymer films (resin films) such as PET film and PEN film and ones on which an organic layer (organic substance layer) such as a polymer layer (resin layer) is formed.

According to the gas barrier layer deposition method of the invention, a silicon nitride film may be basically formed in the same manner as in formation of a silicon nitride film according to a conventional CCP-CVD technique except that this method uses the gas material including silane gas and ammonia gas and the discharge gas including nitrogen gas, and the amounts of these gases and the RF power during film deposition are adjusted within the foregoing specified ranges.

In the practice of the invention, for example, a capacitively coupled CVD device shown in FIG. 1 may be used to deposit a silicon nitride film serving as a gas barrier layer on a substrate.

A plasma-enhanced CVD device that may be used in depositing a gas barrier layer (silicon nitride film) is described below.

FIG. 1 is a diagram schematically showing a plasma-enhanced CVD device that may be used in a gas barrier layer deposition method.

A plasma-enhanced CVD device 10 shown in FIG. 1 is a capacitively coupled plasma-enhanced CVD device in which a silicon nitride film is deposited using, as described above, a gas material including silane gas and ammonia gas and a discharge gas including nitrogen gas.

The plasma-enhanced CVD device 10 includes a vacuum chamber 12, a shower head electrode 14, a lower electrode 16, and a control unit 18. The shower head electrode 14 and the lower electrode 16 are opposed to each other with a specified space S therebetween. The control unit 18 controls the respective sections of the CVD device 10 as will be described later.

The vacuum chamber 12 is used to form a silicon nitride film on a surface Zf of a substrate Z in its interior 12a and is made of any of the materials that may be used in various vacuum chambers as exemplified by stainless steel and aluminum.

The shower head electrode 14 serves as an electrode for discharging plasma P and a member for uniformly supplying above the substrate Z, a gas mixture G including the gas material for forming a silicon nitride film (e.g., silane gas and ammonia gas) and the discharge gas (nitrogen gas).

The shower head electrode 14 has a supply pipe 20 for introducing the gas material (silane gas and ammonia gas) and the discharge gas (nitrogen gas), and a shower head 22 for uniformly supplying the gas mixture G above the substrate Z.

The supply pipe 20 is disposed so as to penetrate through an upper wall 13a of the vacuum chamber 12 to reach the interior 12a. The supply pipe 20 is insulated from the vacuum chamber 12. A gas material supply section 24 is connected to the supply pipe 20.

The gas material supply section 24 supplies to the interior of the vacuum chamber 12 the gas mixture G including silane gas and ammonia gas as the gas material necessary to form a silicon nitride film and nitrogen gas necessary as the discharge gas.

The gas material supply section 24 includes gas cylinders (not shown) for the silane gas, ammonia gas and nitrogen gas, and a flow rate adjuster (not shown) for adjusting the flow rates of the respective gases from these gas cylinders.

In the CCP-CVD device shown in Fig. 1, the gas material supply section 24 individually supplies the silane gas, ammonia gas and nitrogen gas at predetermined flow rates and the vacuum chamber 12 is supplied with the gas mixture G of the silane gas, ammonia gas and nitrogen gas.

The control unit 18 controls the timing at which the gas mixture G (silane gas, ammonia gas and nitrogen gas) is supplied from the gas material supply section 24 as well as the flow rates of the gas mixture G and the respective gases.

The shower head 22 is disposed so as to face a surface 16a of the lower electrode 16. The shower head 22 has a plurality of holes (not shown) uniformly formed at regular intervals. The gas mixture G is supplied to the space S through the holes formed at the shower head 22.

The shape of the shower head 22 is not particularly limited and may be determined by the shape of the substrate Z to be formed and the like.

In the CCP-CVD device shown in Fig. 1, the area of the surface 22a of the shower head 22 in the shower head electrode 14 is regarded as the film deposition area. The surface 22a of the shower head 22 has an area of, for example, 615 cm².

In the CCP-CVD device shown in Fig. 1, the gas flow rate may be changed depending on the area of the surface 22a of the shower head 22. To be more specific, the flow rate per unit area of the surface 22a of the shower head 22 may be set to carry out film deposition.

To the shower head 22 is connected an RF power supply 26 through the supply pipe 20. A matching box 28 for impedance matching is provided between the supply pipe 20 and the RF power supply 26.

The RF power supply 26 is used to generate plasma P in the space S and RF power supplies that may be used in CVD devices well known in the art are usable. This RF power supply 26 is capable of changing the RF power to be applied to the shower head electrode 14 and selecting any frequency within a specified range. The frequency is in a range of, for example, from 13.56 MHz to 60 MHz. The RF power supply 26 is also controlled by the control unit 18 and selects an arbitrary frequency.

The RF power required to deposit a silicon nitride film means the RF power applied during film deposition from the RF power supply 26 of the plasma-enhanced CVD device 10 shown in FIG. 1 to the shower head electrode 14. The RF power is, for example, measured by a wattmeter provided in the RF power supply 26.

The lower electrode 16 cooperates with the shower head electrode 14 to generate plasma P and has a substrate holder (not shown) disposed on its surface 16a. The substrate Z is set on the substrate holder. The lower electrode 16 is grounded.

The lower electrode 16 is disposed so that its surface 16a faces the surface 22a of the shower head 22, and the surface 16a has the same shape and size as those of the surface 22a of the shower head 22. Plasma P is generated in the space S between the surface 22a of the shower head 22 and the surface 16a of the lower electrode 16.

A vacuum evacuation section 30 is connected through an evacuation pipe 32 to a lower wall 13b of the vacuum chamber 12. The vacuum evacuation section 30 adjusts the interior of the vacuum chamber 12 to a predetermined degree of vacuum according to the conditions under which a silicon nitride film is deposited, and has a vacuum pump such as a dry pump or a turbo-molecular pump. The vacuum evacuation section 30 is also controlled by the control unit 18.

The vacuum chamber 12 is provided with a pressure sensor (not shown) for measuring the internal pressure of the vacuum chamber 12. The pressure sensor is also connected to the control unit 18. The pressure measured by the pressure sensor during film deposition indicates the film deposition pressure.

The control unit 18 controls the vacuum evacuation section 30 based on the pressure measured by the pressure sensor so that the gas material and the like can be discharged from the vacuum chamber 12. The control unit 18 can also adjust the internal pressure of the vacuum chamber 12 to a desired value.

The lower electrode 16 is provided with a heating means and/or a cooling means for temperature adjustment, which is driven by a temperature adjusting section 34. The temperature adjusting section 34 is connected to the control unit 18, which adjusts the temperature of the lower electrode 16 through the temperature adjusting section 34 and thus the temperature of the substrate Z.

A method of depositing a gas barrier layer by a plasma-enhanced CVD device is described below.

The substrate Z is first set on the substrate holder disposed on the surface 16a of the lower electrode 16 within the vacuum chamber 12. The vacuum chamber 12 is then closed.

Then, the vacuum chamber 12 is evacuated by the vacuum evacuation section 30. When the internal pressure has reached, for example, 7 × 10⁻⁴ Pa, silane gas, ammonia gas and nitrogen gas are supplied from the gas material supply section 24 to the supply pipe 20, respectively. These gases are supplied as the gas mixture G from the shower head 22 of the shower head electrode 14 to the space S.

In this step, the vacuum evacuation section 30 adjusts the evacuation within the vacuum chamber 12 so that the vacuum chamber 12 has a predetermined internal pressure satisfying the film deposition condition.

Then, a predetermined level of RF power is supplied from the RF power supply 26 to the shower head electrode 14 at an arbitrary frequency in a range of from 13.56 MHz to 60 MHz to generate plasma P above the substrate Z. Formation of a silicon nitride film on the surface Zf of the substrate Z is thus started.

During film deposition, the temperature adjusting means provided in the lower electrode 16 (substrate holder) adjusts the temperature of the substrate Z to, for example, 70°C.

After the plasma P has been turned on, a silicon nitride film is deposited in a preset period of time. After the passage of the preset period of time, supply of the gases and application of the RF voltage are stopped to finish the film deposition. Then, the substrate Z is taken out of the vacuum chamber 12. The silicon nitride film is thus deposited on the surface Zf of the substrate Z.

The gas barrier film having the gas barrier layer deposited by the gas barrier layer deposition method of the invention has high gas barrier properties against oxygen and water vapor. In addition, the gas barrier layer can be formed at a high deposition rate so that the gas barrier film is also produced with high efficiency.

This gas barrier film can be employed, for example, as a sealing film of an organic EL device. In this case, the light-emitting element can be protected from oxygen, water vapor and the like owing to the sealing film having high gas barrier properties. In this way, deterioration of the light-emitting element due to oxygen and water vapor can be minimized. The organic EL device is not the sole application of the gas barrier film and it is needless to say that the gas barrier film may also be applied as appropriate to applications to be protected from oxygen and water vapor.

### REFERENCE EXAMPLES

The present invention is described below in further detail with reference to specific examples as a reference.

### Reference Examples 1 to 15 and Comparative Examples 1 and 2

The capacitively coupled CVD device 10 shown in FIG. 1 was used to form a silicon nitride film on the surface Zf of the substrate Z as a gas barrier layer under the conditions shown in Table 1 to thereby obtain each of barrier films in Reference Examples 1 to 15 and Comparative Examples 1 and 2. These barrier films were evaluated for the evaluation items described below. The results are shown in Table 1.

A polyethylene naphthalate film (PEN film produced by Teijin DuPont Films Japan Limited; trade name: Teonex® Q65FA) was used for the substrate. The lower electrode was set to a temperature of 70°C.

Various gases were supplied at an arbitrary total flow rate selected in a range of from 200 to 3,000 sccm. An arbitrary frequency was selected in a range of from 13.56 MHz to 60 MHz for the RF power supply. The RF power was selected as appropriate in each of Reference Examples 1 to 15 and Comparative Examples 1 and 2.

The barrier films obtained in Reference Examples 1 to 15 and Comparative Examples 1 and 2 were evaluated for the following evaluation items: WVTR, film deposition rate per unit gas flow rate, coloration and transparency of the films (indicated as "Coloration/transparency" in Table 1) and comprehensive evaluation.

The WVTR was measured using a water vapor transmission rate tester, PERMATRAN-W3/33 MG module manufactured by MOCON Inc.

The film deposition rate per unit gas flow rate was measured by the following procedure: First, part of the PEN film as the substrate was masked with Kapton® tape and a silicon nitride film was deposited on the substrate surface. Next, following film deposition, the Kapton® tape was peeled off and the film thickness was measured using a profilometer. The film thickness measured was divided by the plasma turn-on time and further divided by the total flow rate of all the gases to determine the film deposition rate per unit gas flow rate.

As for the coloration and transparency of the film (indicated by "Coloration/transparency" in Table 1), the silicon nitride film formed was visually checked for the color and transparency. The film was rated "good" when the film was transparent and colorless and "fair" when the film was colored.

As for the comprehensive evaluation, the film was rated "good" when it was good for all the items, "fair" when it was not so good in at least one item, "poor" when it was considerably inferior in at least one item. The film was rated "excellent" when it was good for all the items and excellent in at least one item.

Each of the barrier films in Reference Examples 1 to 15 and Comparative Examples 1 and 2 was obtained as described below.

First, the substrate Z taped in part with the Kapton® tape was set on the substrate holder disposed on the surface 16a of the lower electrode 16 within the vacuum chamber 12 shown in FIG. 1, and the vacuum chamber 12 was closed.

Then, the vacuum chamber 12 was evacuated by the vacuum evacuation section 30. When the internal pressure had reached 7 × 10⁻⁴ Pa, silane gas, ammonia gas and nitrogen gas were supplied from the shower head electrode 14 at flow rates predetermined in each of Reference Examples 1 to 15 and Comparative Example 1 and 2.

In addition, the vacuum chamber 12 was evacuated while adjusting the internal pressure so that the vacuum chamber had an internal pressure predetermined in each of Reference Examples 1 to 15 and Comparative Examples 1 and 2.

Then, an arbitrary frequency in a range of from 13.56 MHz to 60 MHz and RF power were selected in each of Reference Examples 1 to 15 and Comparative Example 1 and 2, and the power was supplied from the RF power supply 26 to the shower head electrode 14 to start formation of a silicon nitride film on the surface of the substrate Z.

During film deposition, the temperature adjusting means provided in the substrate holder was used to control the substrate temperature to 70°C.

A silicon nitride film was deposited in a preset period of time. After the passage of the preset period of time, film deposition was finished and the substrate Z having the silicon nitride film (gas barrier layer) formed thereon was taken out of the vacuum chamber 12 to obtain the barrier film.

**<Table 1>**

| | Film deposition condition | | | | Evaluation result | | | |
|---|---|---|---|---|---|---|---|---|
| | RF power/total gas flow rate (W/sccm) | NH₃ flow rate/SiH₄ flow rate | SiH₄ flow rate/total gas flow rate | Film deposition pressure (Pa) | WVTR (g/m²/day) | Film deposition rate per unit gas flow rate (nm/min/sccm) | Coloration transparency | Comprehensive evaluation |
| EX 1 * | 3.0 | 2.0 | 0.10 | 100 | ≤ 0.01 | 0.52 | Good | Excellent |
| EX 2 * | 40.0 | 2.0 | 0.10 | 100 | 0.04 | 0.57 | Good | Good |
| EX 3 * | 0.4 | 2.0 | 0.10 | 100 | 0.05 | 0.42 | Good | Good |
| EX 4 * | 3.0 | 5.0 | 0.10 | 100 | 0.07 | 0.51 | Good | Fair |
| EX 5 * | 3.0 | 4.0 | 0.10 | 100 | 0.03 | 0.51 | Good | Good |
| EX 6 * | 3.0 | 0.4 | 0.10 | 100 | 0.04 | 0.50 | Good | Good |
| EX 7 * | 3.0 | 0.3 | 0.10 | 100 | 0.05 | 0.49 | Fair (yellowish) | Fair |
| EX 8 * | 3.0 | 2.0 | 0.20 | 100 | 0.04 | 0.53 | Fair (slightly cloudy) | Fair |
| EX 9 * | 3.0 | 2.0 | 0.18 | 100 | 0.02 | 0.52 | Good | Good |
| EX 10 * | 3.0 | 2.0 | 0.05 | 100 | 0.03 | 0.45 | Good | Good |
| EX 11 * | 3.0 | 2.0 | 0.03 | 100 | 0.02 | 0.37 | Good | Fair |
| EX 12 * | 3.0 | 2.0 | 0.10 | 230 | 0.04 | 0.54 | Fair (slightly cloudy) | Fair |
| EX 13 * | 3.0 | 2.0 | 0.10 | 220 | 0.04 | 0.54 | Good | Good |
| EX 14 * | 3.0 | 2.0 | 0.10 | 10 | 0.03 | 0.44 | Good | Good |
| EX 15 * | 3.0 | 2.0 | 0.10 | 5 | 0.03 | 0.38 | Good | Fair |
| CE 1 | 45.0 | 2.0 | 0.10 | 100 | 0.15 | 0.58 | Good | Poor |
| CE 2 | 0.3 | 2.0 | 0.10 | 100 | 0.21 | 0.29 | Good | Poor |

| | | | | | | | | |
|---|---|---|---|---|---|---|---|---|
| * Reference Example | | | | | | | | |

As shown in Table 1, Reference Examples 1 to 3, 5, 6, 9, 10, 13 and 14 showed good results on all of the WVTR, film deposition rate per unit gas flow rate and coloration/transparency of film, and also showed good results in the comprehensive evaluation. In particular, Reference Example 1 showed an excellent result on the comprehensive evaluation because of a very low WVTR.

With regard to Reference Examples 4 and 7 that were outside the scope of the invention in particular in the NH₃ flow rate / SiH₄ flow rate (Qa/Qs), Reference Example 4 was rated "fair" in the comprehensive evaluation because the WVTR was lower than in Comparative Examples 1 and 2 but slightly higher than other Reference Examples, and Reference Example 7 was also rated "fair" in the comprehensive evaluation because the film obtained was yellowish compared to other Reference Examples.

With regard to Reference Examples 8 and 11 that were outside the scope of the invention in particular in the SiH₄ flow rate / total gas flow rate (Qs/Q), Reference Example 8 was rated "fair" in the comprehensive evaluation because the film obtained was slightly cloudy compared to other Reference Examples, and Reference Example 11 was also rated "fair" in the comprehensive evaluation because the film deposition rate was slightly lower than in other Reference Examples.

With regard to Reference Examples 12 and 15 that were outside the scope of the invention in particular in the film deposition pressure, Reference Example 12 was rated "fair" in the comprehensive evaluation because the film obtained was slightly cloudy compared to other Reference Examples, and Reference Example 15 was also rated "fair" in the comprehensive evaluation because the film deposition rate was slightly lower than in other Reference Examples.

Comparative Examples 1 and 2 shown in Table 1 were outside the scope of the invention in particular in the RF power / total gas flow rate (P/Q). Comparative Example 1 in which the RF power / total gas flow rate (P/Q) exceeded the upper limit of the invention and the substrate was damaged during film deposition was inferior in the WVTR to Reference Examples 1 to 15, and was therefore rated "poor" in the comprehensive evaluation.

In Comparative Example 2, the RF power / total gas flow rate (P/Q) was less than the lower limit of the invention, a dense film could not be obtained, the WVTR was inferior to that of Reference Examples 1 to 15, and the film deposition rate was low. Therefore, Comparative Example 2 was rated "poor" in the comprehensive result.

## Claims

1. A method of depositing a gas barrier layer, comprising the steps of:
continuously letting an elongated substrate out of a roll having the substrate wound thereon;
supplying a gas material including silane gas and ammonia gas and a discharge gas including nitrogen gas;
continuously carrying out film deposition as the substrate is transported in a longitudinal direction, by depositing a silicon nitride film on the substrate using capacitively coupled chemical vapor deposition to form the gas barrier layer on the substrate; and
taking up the substrate having the gas barrier layer formed thereon,
wherein a ratio P/Q of RF power P (W) required to form the silicon nitride film to a total gas flow rate Q (sccm) of the silane gas, the ammonia gas and the nitrogen gas is in a range of from 0.4 to 40,
**characterized in that**
a ratio Qa/Qs of an ammonia gas flow rate Qa (sccm) to a silane gas flow rate Qs (sccm) is in a range of from 0.4 to 4,
a ratio Qs/Q of a silane gas flow rate Qs to the total flow rate Q of the silane gas, the ammonia gas and the nitrogen gas is in a range of from 0.05 to 0.18,
the silicon nitride film is deposited at a film deposition pressure of from 10 to 220 Pa, and
the temperature of the substrate is adjusted in a range of from 0°C to 150°C.

## Patentansprüche

1. Verfahren zum Abscheiden einer Gasbarrierenschicht, umfassend die Schritte:
kontinuierliches Abrollen eines länglichen Substrats von einer Rolle, die das Substrat aufgewickelt aufweist;
Zuführen eines Gasmaterials, das Silangas und
Ammoniakgas umfasst, und eines Ausstoßgases, das Stickstoffgas umfasst;
kontinuierliches Durchführen einer Filmabscheidung,
wobei das Substrat in Längsrichtung transportiert wird,
durch Abscheiden eines Siliziumnitridfilms auf dem Substrat unter Verwendung von kapazitiv gekuppelter chemischer Dampfphasenabscheidung, um die Gasbarrierenschicht auf dem Substrat zu bilden; und
Aufnehmen des Substrats mit der hierauf gebildeten Gasbarrierenschicht,
worin das Verhältnis P/Q der RF-Kraft P (W), die erforderlich ist, um den Siliziumnitridfilm zu bilden,
zur gesamten Gasflussrate Q (sccm) des Silangases, des Ammoniakgases und des Stickstoffgases im Bereich von 0,4 bis 40 liegt,
**dadurch gekennzeichnet, dass**
das Verhältnis Qa/Qs der Ammoniak-Glasflussrate Qa (sccm) zur Silan-Gasflussrate Qs (sccm) im Bereich von 0,4 bis 4 liegt;
das Verhältnis Qs/Q der Silangasflussrate Qs zur Gesamtflussrate Q des Silangases, des Ammoniakgases und
des Stickstoffgases im Bereich von 0,05 bis 0,18 liegt,
der Siliziumnitridfilm bei einem Filmabscheidungsdruck von 10 bis 220 Pa abgeschieden wird, und
die Temperatur des Substrats im Bereich von 0°C bis 150°C eingestellt wird.

## Revendications

1. Un procédé de déposition d'une couche étanche au gaz, comprenant les étapes consistant à:
sortir continuellement un substrat allongé d'un rouleau ayant le substrat enroulé sur celui-ci,
fournir un matériel gazeux incluant du gaz de silane et du gaz d'ammoniac et un gaz de décharge incluant du gaz d'azote;
effectuer continuellement la déposition d'un film lorsque le substrat est transporté dans une direction longitudinale, en déposant un film de nitrure de silicium sur le substrat en utilisant la déposition chimique en phase vapeur couplée de façon capacitive pour former la couche étanche au gaz sur le substrat; et
récupérer le substrat ayant la couche étanche au gaz formée sur celui-ci,
dans lequel le rapport P/Q entre la puissance RF P (W) requise pour former le film de nitrure de silicium et le débit total de gaz Q (sccm) de gaz de silane, de gaz d'ammoniac et de gaz d'azote est dans une fourchette de 0.4 à 40,
**caractérisé en ce que**
un rapport Qa/Qs entre un débit de gaz d'ammoniac Qa (sccm) et un débit de gaz de silane Qs (sccm) est dans la fourchette de 0.4 à 4,
un rapport Qs/Q entre le débit d'un gaz de silane Qs et le débit total Q de gaz de silane, de gaz d'ammoniac et de gaz d'azote est dans la fourchette de 0.05 à 0.18,
le film de nitrure de silicium est déposé à une pression de déposition de film entre 10 et 220 Pa, et
la température du substrat est ajustée dans une fourchette de 0°C à 150°C.
